# EUROPEAN PATENT APPLICATION

(11) **EP 4 749 683 A1**
(43) Date of publication of application: **27.05.2026**
(21) Application number: 24842853.4
(22) Date of filing: 11.06.2024
(51) Int. Cl.: H01L 21/205, C23C 16/44

(54) **VAPOR PHASE GROWTH APPARATUS**

(30) Priority: 19.07.2023 JP 2023117495
(71) Applicant: Taiyo Nippon Sanso Corporation, Tokyo 142-8558 (JP)
(72) Inventor: YAMAOKA, Yuuya, Tokyo 142-8558 (JP)
(74) Representative: HGF
(86) International application number: PCT/JP2024/021163
(87) International publication number: WO 2025/018057

(57) **Abstract**

The present invention has an object to provide a vapor phase growth apparatus which can automatically transfer a member to an MOCVD reactor and a dry-cleaning apparatus. The present invention provides a vapor phase growth apparatus (1) including: a reaction chamber (10) storing an MOCVD reactor (16) for growing crystals on wafers (W) held in a reactor member (25); a first transfer chamber (45) which is configured to store a first transfer unit for transferring the reactor member and the wafers, the first transfer chamber being disposed adjacent to the reaction chamber and capable of communicating with the reaction chamber; and a cleaning chamber (65) storing a dry-cleaning apparatus (66) for cleaning the reactor member, the cleaning chamber being disposed adjacent to the first transfer chamber and capable of communicating with the first transfer chamber.

## Description

### TECHNICAL FIELD

The present invention relates to a vapor phase growth apparatus.

### BACKGROUND ART

Conventionally, crystals on wafers are grown (semiconductor thin films are formed) in a metal organic chemical vapor deposition (MOCVD) reactor. During crystal growth, reaction products (deposits) are generated in the MOCVD reactor. The reaction products adhere to reactor members, such as a susceptor cover, used in the MOCVD reactor. Therefore, the reaction products adhered to the reactor members must be removed using, for example, a dry-cleaning apparatus (dry-cleaning furnace) as disclosed in Patent Document 1.

### PRIOR ART DOCUMENTS

### PATENT LITERATURE

Patent Document 1: Japanese Unexamined Patent Application, First Publication No. 2012-186311

### SUMMARY OF INVENTION

### PROBLEM TO BE SOLVED BY THE INVENTION

However, conventionally, the transfer of wafers and reactor members to the MOCVD reactor and the transfer of reactor members to the dry-cleaning apparatus are performed by workers. This results in the problem of longer times required for crystal growth on the wafers.

The present invention has been made in view of the above problems, and has an object to provide a vapor phase growth apparatus which can automatically transfer a member to an MOCVD reactor and a dry-cleaning apparatus.

### MEANS FOR SOLVING THE PROBLEM

In order to solve the above problems, the present invention proposes the following aspects.
(1) Aspect 1 of the present invention is a vapor phase growth apparatus including: a reaction chamber storing an MOCVD reactor for growing crystals on wafers held in a reactor member; a first transfer chamber which is configured to store a first transfer unit for transferring the reactor member and the wafers, the first transfer chamber being disposed adjacent to the reaction chamber and capable of communicating with the reaction chamber; and a cleaning chamber storing a dry-cleaning apparatus for cleaning the reactor member, the cleaning chamber being disposed adjacent to the first transfer chamber and capable of communicating with the first transfer chamber.

In this invention, a crystal can be grown on a wafer held in a reactor member by the MOCVD reactor, and the reactor member can be cleaned by the dry-cleaning apparatus.

The reaction chamber storing the MOCVD reactor and the cleaning chamber storing the dry-cleaning apparatus are arranged adjacent to each other with respect to the first transfer chamber storing the first transfer unit, and can each communicate with the first transfer chamber. As a result, the distance between the reaction chamber and the first transfer chamber and the distance between the cleaning chamber and the first transfer chamber are shorter than when, for example, other chambers are arranged between the reaction chamber and the first transfer chamber or between the cleaning chamber and the first transfer chamber.

As a result, the first transfer unit can automatically transfer the wafers and the reactor members to the MOCVD reactor and transfer the reactor member to the dry-cleaning apparatus through the communicating parts.

(2) Aspect 2 of the present invention is the vapor phase growth apparatus according to (1), further including a reaction atmosphere unit which fills the reaction chamber with an inert gas, a first transfer atmosphere unit which fills the first transfer chamber with the inert gas, and a control unit which controls the reaction atmosphere unit and the first transfer atmosphere unit, wherein the control unit makes the pressure of the inert gas in the first transfer chamber by the first transfer atmosphere unit higher than the pressure of the inert gas in the reaction chamber by the reaction atmosphere unit.

In this invention, the reaction atmosphere unit can fill the reaction chamber with an inert gas, and the first transfer atmosphere unit can fill the first transfer chamber with an inert gas. The control unit then makes the pressure of the inert gas in the first transfer chamber by the first transfer atmosphere unit higher than the pressure of the inert gas in the reaction chamber by the reaction atmosphere unit. As a result, the inert gas flows from the first transfer chamber toward the reaction chamber through a portion where the first transfer chamber and the reaction chamber communicate. This makes it possible to prevent reaction products generated in the MOCVD reactor from flowing into the first transfer chamber through the communicating portion.

(3) Aspect 3 of the present invention is the vapor phase growth apparatus according to (1) or (2), further including a cleaning atmosphere unit which fills the cleaning chamber with an inert gas.

In this invention, by filling the cleaning chamber with an inert gas using the cleaning atmosphere unit, it is possible to prevent the wafer from being exposed to the atmosphere not only in the first transfer chamber and the reaction chamber, but also in the cleaning chamber.

(4) Aspect 4 of the present invention is the vapor phase growth apparatus according to any one of (1) to (3), further comprising: a second transfer chamber storing a second transfer unit which is configured to transfer the wafer between the first transfer chamber, the second transfer chamber being arranged adjacent to the first transfer chamber and being capable of communicating with the first transfer chamber; and a second transfer atmosphere unit which fills the second transfer chamber with the inert gas, wherein the control unit makes the pressure of the inert gas in the second transfer chamber by the second transfer atmosphere unit higher than the pressure of the inert gas in the first transfer chamber by the first transfer atmosphere unit.

In this invention, the second transfer unit can transfer the wafers between the first transfer chamber and the second transfer chamber through a portion where the second transfer chamber and the first transfer chamber communicate. The second transfer chamber can be filled with inert gas by the second transfer atmosphere unit.

In this case, the control unit makes the pressure of the inert gas in the second transfer chamber by the second transfer atmosphere unit higher than the pressure of the inert gas in the first transfer chamber by the first transfer atmosphere unit. This prevents reaction products generated in the MOCVD reactor from flowing into the second transfer chamber through the first transfer chamber.

(5) A fifth aspect of the present invention is the vapor phase growth apparatus according to (2), wherein the dew point of the inert gas is -40°C or lower and the inert gas does not contain oxygen gas.

In this invention, in addition to preventing moisture in the inert gas from adhering to the wafer, it is also possible to prevent oxidation of the wafer or the like in an inert gas atmosphere.

(6) Aspect 6 of the present invention is the vapor phase growth apparatus according to any one of (1) to (5), wherein the first transfer unit is capable of changing its orientation so as to face either the reaction chamber or the cleaning chamber with a support surface which supports the reactor member facing upward.

In this invention, the reactor member supported on the support surface can be prevented from falling off the support surface. In this state, the orientation of the first transfer unit can be changed so that it faces either the reaction chamber or the cleaning chamber.

### EFFECTS OF THE INVENTION

According to the vapor phase growth apparatus of the present invention, transfer to the MOCVD reactor and transfer to the dry-cleaning apparatus can be performed automatically.

### BRIEF DESCRIPTION OF DRAWINGS

[FIG. 1] A schematic cross-sectional plan view of a vapor phase growth apparatus according to a first embodiment of the present invention.
[FIG. 2] A cross-sectional view of an MOCVD reactor of the vapor phase growth apparatus.
[FIG. 3] A front view of a locking piece of the vapor phase growth apparatus.
[FIG. 4] A diagram illustrating the operation of the vapor phase growth apparatus.
[FIG. 5] A flowchart showing the processes of the vapor phase growth apparatus.
[FIG. 6] A diagram illustrating the operation of the vapor phase growth apparatus.
[FIG. 7] A diagram illustrating the operation of the vapor phase growth apparatus.

### DETAILED DESCRIPTION OF THE PREFERRED EMBODIMENTS

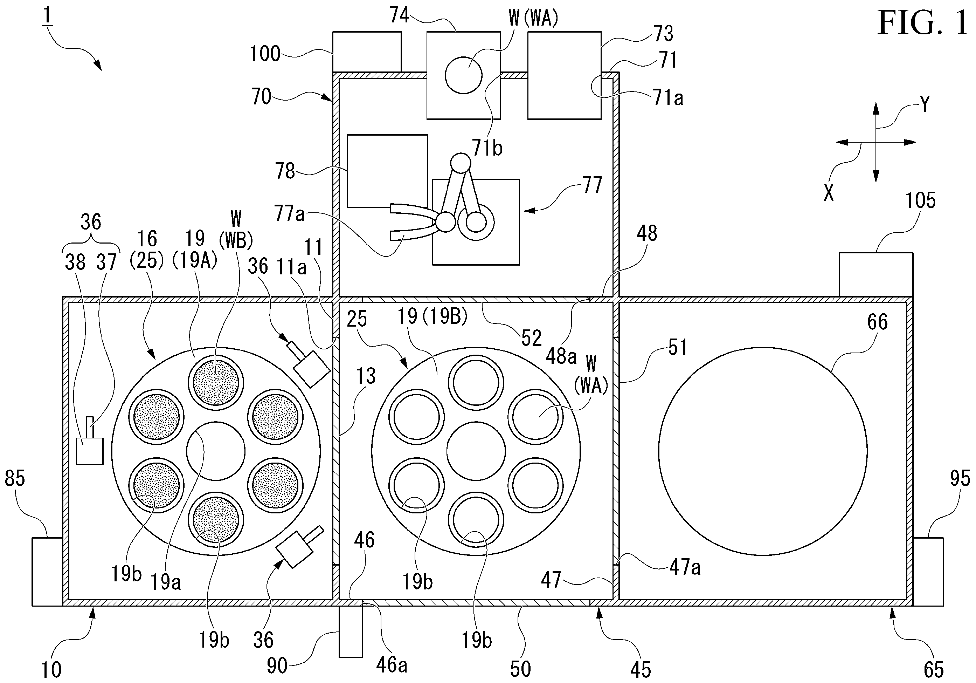

One embodiment of a vapor phase growth apparatus according to the present invention will now be described with reference to FIGS 1 to 7.

As shown in FIG. 1, the vapor phase growth apparatus 1 of the present embodiment includes a reaction chamber 10, a first transfer chamber 45, a cleaning chamber 65, a second transfer chamber 70, a reaction atmosphere unit 85, a first transfer atmosphere unit 90, a cleaning atmosphere unit 95, a second transfer atmosphere unit 100, and a control section 105.

For example, the reaction chamber 10, first transfer chamber 45, cleaning chamber 65, and second transfer chamber 70 are each formed in a box shape. The cross sections of the reaction chamber 10, first transfer chamber 45, cleaning chamber 65, and second transfer chamber 70 in a plan view are each formed in the shape of a rectangular outer edge (frame shape).

In FIG. 1, only the susceptor cover 19 of the MOCVD reactor 16, which will be described later, is shown.

The reaction chamber 10 has a sidewall 11. An opening 11a (a communicating portion) is formed in the sidewall 11, penetrating the sidewall 11. The opening 11a is formed in the center of the sidewall 11. A gate valve 13, which serves as a shutter, is attached to the opening 11a. The gate valve 13 can open and close the opening 11a.

The reaction chamber 10 stores an MOCVD reactor 16 and multiple temporary support arms 36.

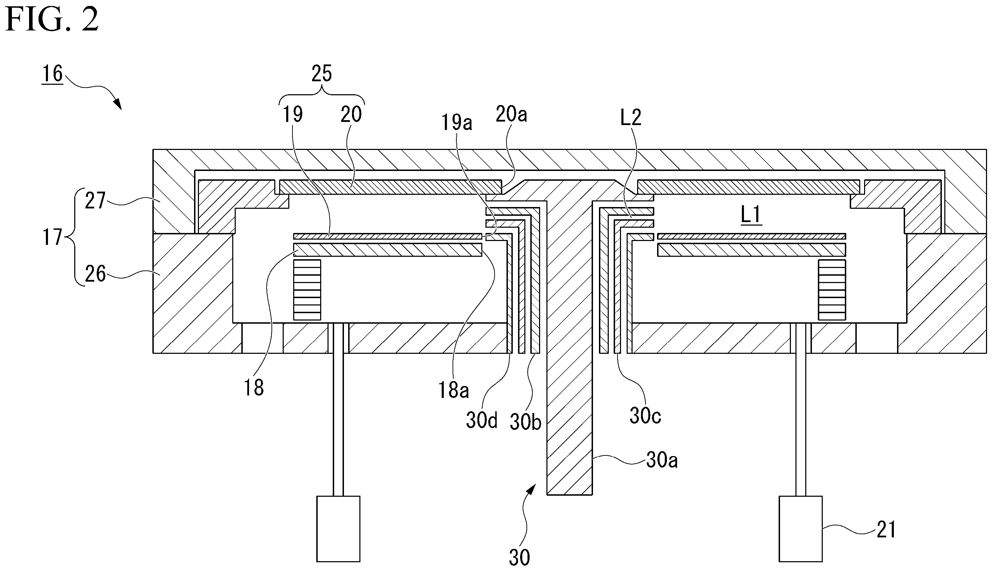

The MOCVD reactor 16 is a device with a known configuration. As shown in FIGS. 1 and 2, the MOCVD reactor 16 has a chamber 17, a susceptor 18, a susceptor cover 19, a ceiling plate 20, and a push-up lifting mechanism 21. The susceptor cover 19 and the ceiling plate 20 constitute a reactor member 25.

As shown in FIG. 2, the chamber 17 has a chamber body 26 and a chamber lid 27. The chamber body 26 is formed in a cylindrical shape with a bottom. The chamber lid 27 is formed in a cylindrical shape with a top. The chamber lid 27 is positioned higher than the chamber body 26 and covers the opening of the chamber body 26. The chamber lid 27 is movable in the vertical direction relative to the chamber body 26.

The susceptor 18 is formed in a disk shape. An opening 18a is formed in the center of the susceptor 18, through which the nozzle portion 30, described below, can be inserted.

As shown in FIGS.1 and 2, the susceptor cover 19 is formed in a disk shape which is substantially the same as the shape of the susceptor 18. An opening 19a is formed in the center of the susceptor cover 19, through which a nozzle portion 30 (described later) can be inserted. As shown in FIG. 1, a plurality of wafer pockets 19b are formed around the opening 19a in the susceptor cover 19. The wafer W is held in the wafer pockets 19b of the susceptor cover 19 (reactor member 25).

In addition, as shown in FIG. 2, the ceiling plate 20 is formed in a circular disk shape which is larger than the susceptor 18 in a plan view. An opening 20a is formed in the center of the ceiling plate 20, through which the nozzle portion 30, described below, can be inserted. The ceiling plate 20 is positioned above the susceptor cover 19 so as to face the susceptor cover 19.

A flow path L1 for a source gas is formed between the ceiling plate 20 and the susceptor cover 19, for growing crystals on the wafer W to form a semiconductor thin film (growing crystals on the wafer W).

The nozzle section 30 is disposed in the center of the chamber body 26 and fits into the peripheral edge of the opening 20a in the ceiling plate 20. The nozzle section 30 supports the ceiling plate 20 and supplies the source gas to the flow path L1.

The nozzle section 30 has a first nozzle wall 30a, a second nozzle wall 30b, a third nozzle wall 30c, and a fourth nozzle wall 30d.

The first nozzle wall 30a has a cylindrical shape extending in the vertical direction, with the upper end projecting radially outward. The second nozzle wall 30b is formed in a tubular shape with a diameter larger than the cylindrical diameter of the first nozzle wall 30a, and has a flange at its upper end. The third nozzle wall 30c is formed in a tubular shape with a diameter larger than the outer diameter of the tubular portion of the second nozzle wall 30b, and has a flange at its upper end. The fourth nozzle wall 30d is formed in a tubular shape with a diameter larger than the outer diameter of the tubular portion of the third nozzle wall 30c, and has a flange at its upper end.

The first nozzle wall 30a, second nozzle wall 30b, third nozzle wall 30c, and fourth nozzle wall 30d are arranged in a nested manner.

The space formed between radially adjacent walls of the first nozzle wall 30a, second nozzle wall 30b, third nozzle wall 30c, and fourth nozzle wall 30d serves as a source gas introduction path L2.

For example, when the semiconductor thin film is gallium nitride, the source gas includes an organic metal gas, ammonia gas, and purge gas.

For example, the push-up lifting mechanism 21 can move the susceptor cover 19 in the vertical direction.

As shown in FIGS. 1 and 2, the vapor phase growth apparatus 1 is equipped with two sets of reactor members 25, each having a susceptor cover 19 and a ceiling plate 20. Hereinafter, one of the two sets of reactor members 25 will be referred to as susceptor cover 19A, and the other will be referred to as susceptor cover 19B.

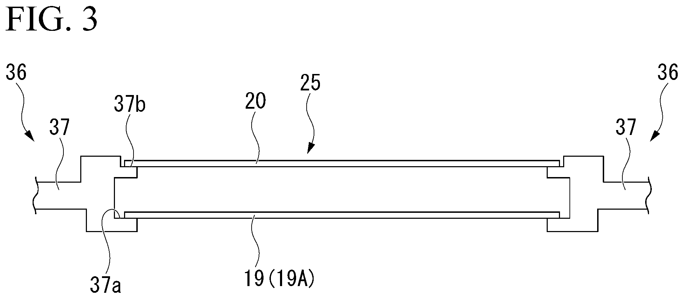

As shown in FIG. 1, the temporary support arm 36 has a locking piece 37 and a moving portion 38. As shown in FIG. 3, the locking piece 37 is formed with a first step portion 37a and a second step portion 37b. The second step portion 37b is positioned higher than the first step portion 37a.

The first step portion 37a can be locked onto the susceptor cover 19 from below the susceptor cover 19. The second step portion 37b can be locked onto the ceiling plate 20 from below the ceiling plate 20.

The moving portion 38 moves the locking piece 37 up and down and in directions along the horizontal plane.

As shown in FIG. 1, the first transfer chamber 45 shares the sidewall 11 with the reaction chamber 10. The first transfer chamber 45 is positioned adjacent to the sidewall 11 of the reaction chamber 10. The first transfer chamber 45 has sidewalls 46, 47, and 48.

When the gate valve 13 is open, the first transfer chamber 45 communicates with the reaction chamber 10. In this way, the first transfer chamber 45 can communicate with the reaction chamber 10.

The reaction chamber 10 and the first transfer chamber 45 are arranged side by side in the first direction X along a horizontal plane.

The sidewall 11 and the sidewall 47 are arranged opposite each other. The sidewall 46 and the sidewall 48 are arranged opposite each other.

Similar to the opening 11a in the sidewall 11, openings 46a, 47a, and 48a are formed in the sidewalls 46, 47, and 48, respectively. Gate valves 50, 51, and 52 similar to the gate valve 13 are attached to the openings 46a, 47a, and 48a, respectively.

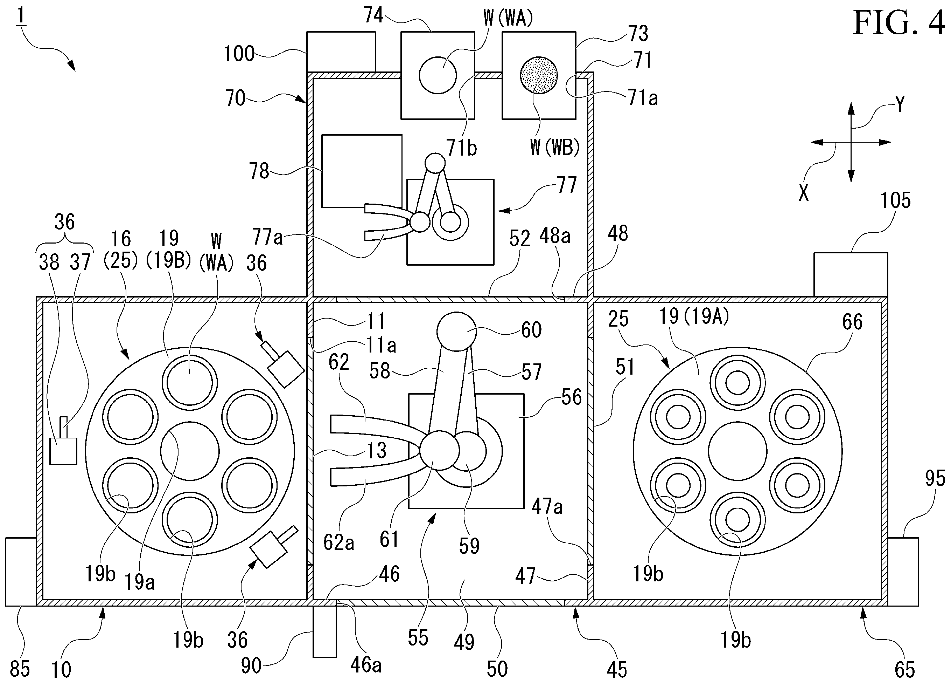

The first transfer chamber 45 stores a first robot arm (first transfer unit) 55 shown in FIG. 4. The first robot arm 55 transfers the reactor member 25 and the wafer W.

Details of the first robot arm 55 will be described later.

As shown in FIG. 1, the cleaning chamber 65 shares a sidewall 47 with the first transfer chamber 45. The cleaning chamber 65 is located on the opposite side of the first transfer chamber 45 from the reaction chamber 10. The reaction chamber 10, the first transfer chamber 45, and the cleaning chamber 65 are arranged in the first direction X in the following order: reaction chamber 10, first transfer chamber 45, and cleaning chamber 65.

The cleaning chamber 65 is located adjacent to the first transfer chamber 45 on the side of the sidewall 47. When the gate valve 51 is open, the cleaning chamber 65 communicates with the first transfer chamber 45. In this way, the cleaning chamber 65 can communicate with the first transfer chamber 45.

The cleaning chamber 65 stores a well-known dry-cleaning apparatus 66. The dry-cleaning apparatus 66 cleans the reactor member 25.

The second transfer chamber 70 is a so-called CtoC chamber, into which the wafers W are transferred from outside the vapor phase growth apparatus 1 using cassettes 73 and 74, which will be described later.

The second transfer chamber 70 shares the sidewall 48 with the first transfer chamber 45. The second transfer chamber 70 is positioned adjacent to the sidewall 48 side of the first transfer chamber 45. The first transfer chamber 45 and the second transfer chamber 70 are positioned along a horizontal plane and side by side in a second direction Y, which is perpendicular to the first direction X.

The second transfer chamber 70 has a sidewall 71 positioned opposite the sidewall 48. Openings 71a and 71b are formed in the sidewall 71 and penetrate the sidewall 71. The openings 71a and 71b are positioned side by side along the sidewall 71.

When the gate valve 52 is open, the second transfer chamber 70 communicates with the first transfer chamber 45. In this manner, the second transfer chamber 70 can communicate with the first transfer chamber 45.

The cassettes 73 and 74 capable of storing wafers W are disposed in openings 71a and 71b, respectively. For example, the cassette 73 stores wafers W (hereinafter also referred to as wafers WB (see FIG. 4)) after a semiconductor thin film has been formed thereon. Wafers WB are indicated by hatching below. The cassette 74 stores wafers W (hereinafter also referred to as wafers WA) before a semiconductor thin film has been formed thereon.

The second transfer chamber 70 stores a second robot arm (second transfer unit) 77 and an orienter 78. The second robot arm 77 transfers the wafers W between the second transfer chamber 70 and the first transfer chamber 45. Details of the second robot arm 77 will be described later.

The orienter 78 is used to adjust the phase of the wafers W.

As shown in FIG. 4, for example, the first robot arm 55 has a base 56, links 57 and 58, joints 59, 60, and 61, and a support 62.

The base 56 is disposed on the bottom wall 49 of the first transfer chamber 45. For example, the joint 59 adjusts the angle between the base 56 and the link 57, that is, the orientation of the link 57 relative to the base 56. The joint 60 adjusts the angle between the link 57 and the link 58, that is, the orientation of the link 58 relative to the link 57. The joint 61 adjusts the angle between the link 58 and the support 62, that is, the orientation of the support 62 relative to the link 58.

The upper surface of the support portion 62 is a support surface 62a which supports the reactor member 25.

The first robot arm 55 can change its own orientation (first robot arm 55) through known control by the control unit 105 so that it faces either the reaction chamber 10, the cleaning chamber 65, or the second transfer chamber 70 with the support surface 62a facing upward.

The first transfer unit is not limited to the first robot arm 55, and may be an automatically moving robot, and the like.

The second robot arm 77 has a configuration similar to the first robot arm 55. The second robot arm 77 can change its own orientation so that it faces either the first transfer chamber 45 or the side wall 71 with the support surface 77a facing upward.

As shown in FIG. 1, the reaction atmosphere unit 85 fills the reaction chamber 10 with nitrogen gas (inert gas). Note that the inert gas is not limited to nitrogen gas, and may be carbon dioxide gas, helium gas, and the like.

The dew point of the nitrogen gas is preferably -40°C or lower. In other words, the dew point of the water vapor contained in the nitrogen gas is preferably -40°C or lower. It is preferable that the nitrogen gas does not contain oxygen gas.

For example, the reaction atmosphere unit 85 includes piping, an on-off valve, a pressure gauge, and a scrubber (gas treatment device), all of which are not shown.

A first end of the piping is connected to the side wall of the reaction chamber 10, communicating with the interior of the reaction chamber 10 and supplying nitrogen gas into the reaction chamber 10. A second end of the piping, opposite the first end, is connected to the scrubber (gas treatment device, not shown). The reaction atmosphere unit 85 can evacuate air and other substances from the reaction chamber 10 or supply nitrogen gas into the reaction chamber 10 through the piping.

An on-off valve and a pressure gauge are provided on the piping. The pressure gauge measures the pressure inside the reaction chamber 10 through the piping. The pressure gauge may also be provided on the side wall of the reaction chamber 10. The on-off valve opens and closes the piping, and connects and disconnects the piping from the outside.

The first transfer atmosphere unit 90, the cleaning atmosphere unit 95, and the second transfer atmosphere unit 100 are configured in the same manner as the reaction atmosphere unit 85.

The first transfer atmosphere unit 90 is provided in the first transfer chamber 45. The first transfer atmosphere unit 90 fills the first transfer chamber 45 with nitrogen gas.

The cleaning atmosphere unit 95 is provided in the cleaning chamber 65. The cleaning atmosphere unit 95 fills the cleaning chamber 65 with nitrogen gas.

The second transfer atmosphere unit 100 is provided in the second transfer chamber 70. The second transfer atmosphere unit 100 fills the second transfer chamber 70 with nitrogen gas.

The control unit 105 has a CPU (Central Processing Unit) and memory, not shown.

The control unit 105 is connected to the gate valves 13, 50, 51, and 52, the moving unit 38 of the temporary support arm 36, the on-off valves of the atmospheric units 85, 90, 95, and 100, and the pressure gauge. The control unit 105 controls the gate valves 13, 50, 51, and 52, the moving unit 38, and the on-off valves of the atmospheric units 85, 90, 95, and 100.

Next, the operation of the vapor phase growth apparatus 1 configured as described above will be described.

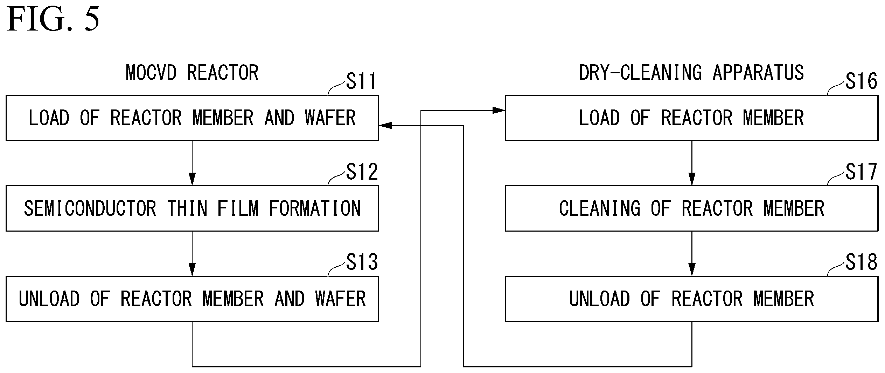

FIG. 5 is a flowchart showing the processes of the vapor phase growth apparatus 1.

In FIG. 1, wafer pockets 19b of a susceptor cover 19A inside the MOCVD reactor 16 hold wafers WB after a semiconductor thin film has been formed thereon in the MOCVD reactor 16. Note that when a semiconductor thin film is formed on the wafer WB, reaction products are generated in the MOCVD reactor 16. Examples of the reaction products include amorphous semiconductor thin films (such as gallium nitride) and unreacted organometallic components.

In the first transfer chamber 45, the support surface 62a of the first robot arm 55 supports a reactor member 25 having a susceptor cover 19B. The wafer pockets 19b of the susceptor cover 19B hold wafers WA before a semiconductor thin film is formed thereon in the MOCVD reactor 16.

The gate valves 13, 50, 51, and 52 are closed.

The control unit 105 first fills the reaction chamber 10, first transfer chamber 45, cleaning chamber 65, and second transfer chamber 70 with nitrogen gas using the atmosphere units 85, 90, 95, and 100. During this process, the control unit 105 sets the pressure of the nitrogen gas in the second transfer chamber 70 by the second transfer atmosphere unit 100 higher than the pressure of the nitrogen gas in the first transfer chamber 45 by the first transfer atmosphere unit 90.

Furthermore, the control unit 105 sets the pressure of the nitrogen gas in the first transfer chamber 45 by the first transfer atmosphere unit 90 higher than the pressures of the nitrogen gas in the reaction chamber 10 and the cleaning chamber 65 by the reaction atmosphere unit 85 and the cleaning atmosphere unit 95, respectively.

For example, the control unit 105 adjusts the pressure of the nitrogen gas in the reaction chamber 10 by opening and closing an on-off valve based on the pressure in the reaction chamber 10 measured by the pressure gauge.

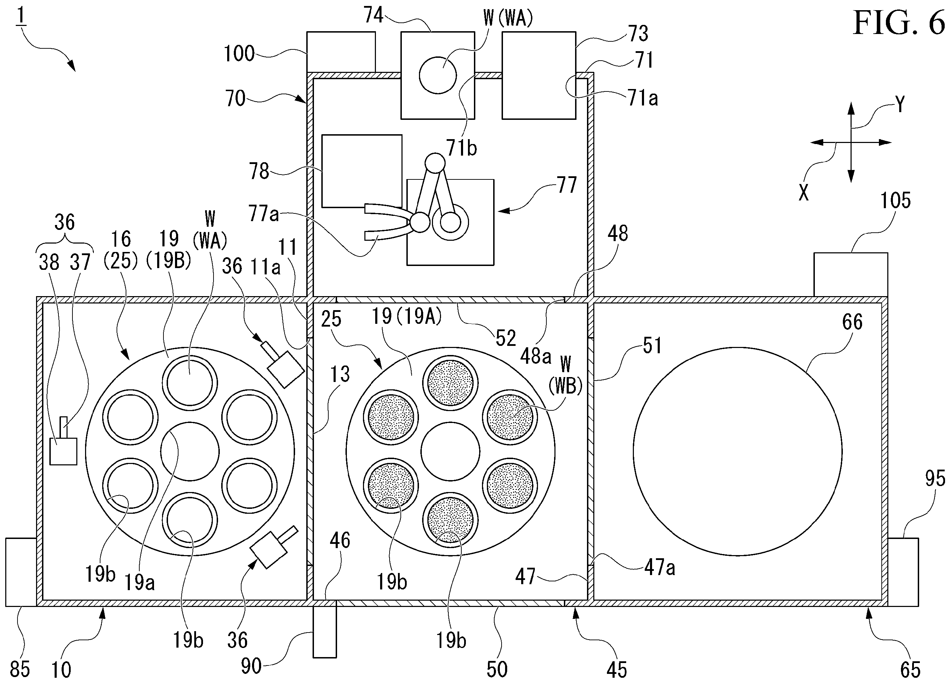

First, as shown in FIG. 6, the reactor member 25 having the susceptor cover 19B in the first transfer chamber 45 is swapped with the reactor member 25 having the susceptor cover 19A in the reaction chamber 10. That is, step S11, which involves loading the reactor member 25 and wafer WA into the MOCVD reactor 16, and step S13, which involves unloading the reactor member 25 and wafer WB from the MOCVD reactor 16, are performed in parallel.

At this time, for example, the chamber lid 27 is moved upward relative to the chamber body 26 of the MOCVD reactor 16. The control unit 105 causes the multiple moving units 38 to engage the susceptor cover 19A and ceiling plate 20 in the reaction chamber 10 with the step portions 37a, 37b of the multiple engaging pieces 37, as shown in FIG. 3, and retracts the susceptor cover 19A and ceiling plate 20 attached to the MOCVD reactor 16 upward within the reaction chamber 10.

The control unit 105 opens the gate valve 13 and changes the direction of the first robot arm 55 so that it faces the reaction chamber 10. The first robot arm 55 transfers the susceptor cover 19B and the ceiling plate 20 supported by the support surface 62a into the reaction chamber 10 through the opening 11a in the side wall 11 and attaches them to the MOCVD reactor 16.

The susceptor cover 19A and ceiling plate 20, supported by the multiple locking pieces 37, are supported by the support surface 62a of the first robot arm 55. The first robot arm 55 moves the supported susceptor cover 19A and ceiling plate 20 into the first transfer chamber 45.

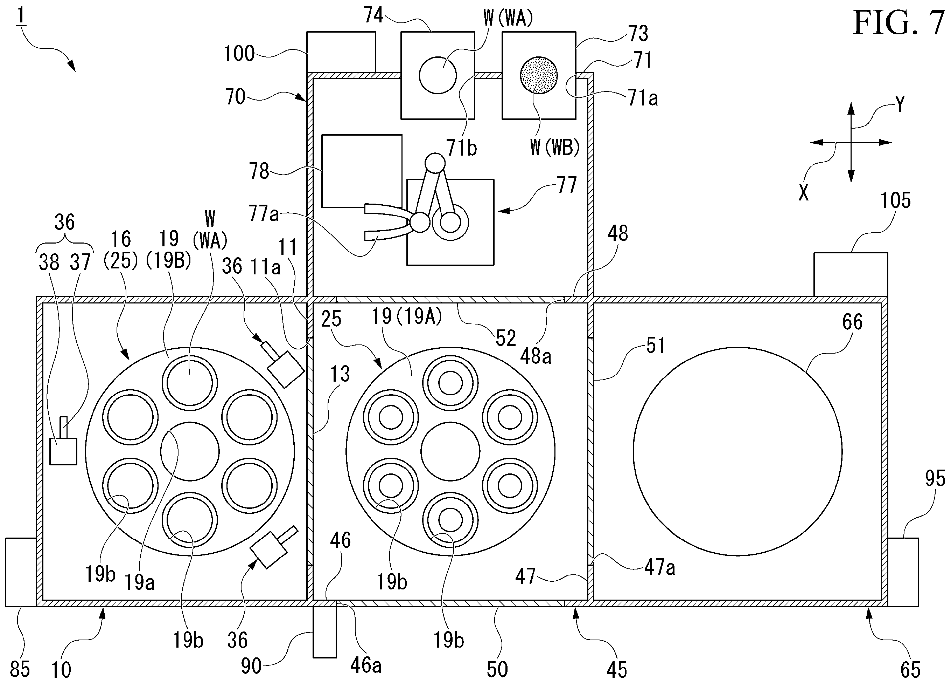

Next, as shown in FIG. 7, the control unit 105 opens the gate valve 52 and causes the second robot arm 77 to move the wafer WB held by the susceptor cover 19A to the cassette 73 within the first transfer chamber 45.

In parallel with steps S11 and S13, as shown in FIG. 4, the first robot arm 55 loads the reactor member 25 having the susceptor cover 19A supported by the support surface 62a, into the dry-cleaning apparatus 66 within the cleaning chamber 65 (step S16).

Next, a semiconductor thin film is formed on the wafer WA held by the susceptor cover 19B in the MOCVD reactor 16 to produce a wafer WB (step S12). The formation of the semiconductor thin film in the MOCVD reactor 16 is performed using a known procedure. In parallel with step S12, the reactor member 25 having the susceptor cover 19A is cleaned in the dry-cleaning apparatus 66 (step S17).

Next, as shown in FIG. 6, the first robot arm 55 supports the reactor member 25 having the susceptor cover 19A cleaned in the dry-cleaning apparatus 66 on the support surface 62a and transfers it into the first transfer chamber 45 (step S18).

The second robot arm 77 holds the wafer WA in the cassette 74 before a semiconductor thin film is formed thereon in the wafer pocket 19b of the susceptor cover 19A.

Next, the susceptor cover 19A in the first transfer chamber 45 is swapped with the susceptor cover 19B in the reaction chamber 10. That is, step S11, which loads the reactor member 25 and the wafer WA into the MOCVD reactor 16, and step S13, which unloads the reactor member 25 and the wafer WB, are performed in parallel.

By performing steps S11 to S18 performed on susceptor cover 19A on susceptor cover 19B with the steps shifted, semiconductor thin films can be formed alternately on wafers WA held by susceptor covers 19A and 19B.

As described above, in the vapor phase growth apparatus 1 of the present embodiment, a crystal can be grown on a wafer W held in the reactor member 25 by the MOCVD reactor 16, and the reactor member 25 can be cleaned by the dry-cleaning apparatus 66.

The reaction chamber 10, which stores the MOCVD reactor 16, and the cleaning chamber 65, which stores the dry-cleaning apparatus 66, are arranged adjacent to each other with respect to the first transfer chamber 45, which stores the first robot arm 55, and can each communicate with the first transfer chamber 45. Therefore, the distance between the reaction chamber 10 and the first transfer chamber 45 and the distance between the cleaning chamber 65 and the first transfer chamber 45 are shorter than when, for example, other chambers are arranged between the reaction chamber 10 and the first transfer chamber 45 and between the cleaning chamber 65 and the first transfer chamber 45.

Therefore, the first robot arm 55 can automatically transfer the wafer W and the reactor member 25 to the MOCVD reactor 16 through the communicating part, and can also automatically transfer the reactor member 25 to the dry-cleaning apparatus 66.

The vapor phase growth apparatus 1 includes the reaction atmosphere unit 85, the first transfer atmosphere unit 90, and the control unit 105. Therefore, the reaction chamber 10 can be filled with nitrogen gas by the reaction atmosphere unit 85, and the first transfer chamber 45 can be filled with nitrogen gas by the first transfer atmosphere unit 90.

The control unit 105 then makes the pressure of the nitrogen gas in the first transfer chamber 45 by the first transfer atmosphere unit 90 higher than the pressure of the nitrogen gas in the reaction chamber 10 by the reaction atmosphere unit 85. Therefore, nitrogen gas flows from the first transfer chamber 45 toward the reaction chamber 10 through the communication between the first transfer chamber 45 and the reaction chamber 10. This prevents reaction products generated in the MOCVD reactor 16 from flowing into the first transfer chamber 45 through the communication.

If the vapor phase growth apparatus did not include the first transfer chamber 45 and the first robot arm 55, an operator would transfer the reactor member 25 between the MOCVD reactor 16 and the dry-cleaning apparatus 66. The transferred reactor member 25 was exposed to the atmosphere. Therefore, baking of the reactor member 25 was necessary before step S12, which is the growth of a semiconductor thin film on the reactor member 25.

In the vapor phase growth apparatus 1 of the present embodiment, the reactor member 25 is not exposed to the atmosphere in the first transfer chamber 45, so baking of the reactor member 25 is not necessary. Therefore, the cycle time required for processing wafers W can be shortened compared to conventional vapor phase growth apparatuses.

The vapor phase growth apparatus 1 includes the cleaning atmosphere unit 95. By filling the cleaning chamber 65 with nitrogen gas using the cleaning atmosphere unit 95, it is possible to prevent the reactor member 25 from being exposed to the atmosphere not only in the first transfer chamber 45 and the reaction chamber 10 but also in the cleaning chamber 65.

The vapor phase growth apparatus 1 includes the second transfer chamber 70 and the second transfer atmosphere unit 100, and the pressure of the nitrogen gas in the second transfer chamber 70 by the second transfer atmosphere unit 100 is made higher than the pressure of the nitrogen gas in the first transfer chamber 45 by the first transfer atmosphere unit 90.

The second robot arm 77 can transfer a wafer W between the first transfer chamber 45 and the second transfer chamber 70 through a portion where the second transfer chamber 70 and the first transfer chamber 45 communicate. The second transfer atmosphere unit 100 can fill the second transfer chamber 70 with nitrogen gas.

At this time, the control unit 105 makes the pressure of the nitrogen gas in the second transfer chamber 70 by the second transfer atmosphere unit 100 higher than the pressure of the nitrogen gas in the first transfer chamber 45 by the first transfer atmosphere unit 90. Therefore, the reaction products generated in the MOCVD reactor 16 can be prevented from flowing into the second transfer chamber 70 through the first transfer chamber 45.

The dew point of nitrogen gas may be -40°C or lower, and the nitrogen gas may not contain oxygen gas. In this case, not only moisture in the nitrogen gas is prevented from adhering to the wafer W, but oxidation of the wafer W and other objects in the nitrogen gas atmosphere can also be prevented.

The first robot arm 55 can change its orientation so that it faces either the reaction chamber 10, the cleaning chamber 65, or the second transfer chamber 70, with the support surface 62a facing upward. This prevents the reactor member 25 supported on the support surface 62a from falling off the support surface 62a. In this state, the orientation of the first robot arm 55 can be changed so that it faces either the reaction chamber 10, the cleaning chamber 65, or the second transfer chamber 70.

An embodiment of the present invention has been described in detail above with reference to the drawings, but the specific configuration is not limited to this embodiment, and configuration changes, combinations, deletions, and the like are also included within the scope of the gist of the present invention.

For example, in the above embodiment, the reaction chamber 10, the first transfer chamber 45, and the cleaning chamber 65 are arranged in this order in the first direction X. However, the cleaning chamber may be arranged on the opposite side of the first transfer chamber 45 from the second transfer chamber 70, and the reaction chamber 10, the first transfer chamber 45, and the cleaning chamber may be arranged in an L-shape in plan view.

In the embodiment, the control unit 105 may control the pressure of the nitrogen gas in the second transfer chamber 70 by the second transfer atmosphere unit 100 to be equal to or lower than the pressure of the nitrogen gas in the first transfer chamber 45 by the first transfer atmosphere unit 90. The control unit 105 may control the pressure of the nitrogen gas in the first transfer chamber 45 by the first transfer atmosphere unit 90 to be equal to or lower than the pressure of the nitrogen gas in the reaction chamber 10 and the cleaning chamber 65 by the reaction atmosphere unit 85 and the cleaning atmosphere unit 95.

The support surface 62a of the first robot arm 55 may face sideways.

The vapor phase growth apparatus 1 may not include the second transfer chamber 70, the atmosphere units 85, 90, 95, 100, and the control section 105.

### EXPLANATION OF REFERENCE NUMERAL

- 1: vapor phase growth apparatus
- 10: reaction chamber
- 16: MOCVD reactor
- 25: reactor member
- 45: first transfer chamber
- 55: first robot arm (first transfer unit)
- 62a: support surface
- 65: cleaning chamber
- 66: dry-cleaning apparatus
- 70: second transfer chamber
- 85: reaction atmosphere
- 90: first transfer atmosphere
- 95: cleaning atmosphere
- 100: second transfer atmosphere
- 105: control unit
- W: wafer

## Claims

1. A vapor phase growth apparatus comprising:
a reaction chamber storing an MOCVD reactor for growing crystals on wafers held in a reactor member;
a first transfer chamber which is configured to store a first transfer unit for transferring the reactor member and the wafers, the first transfer chamber being disposed adjacent to the reaction chamber and capable of communicating with the reaction chamber; and
a cleaning chamber storing a dry-cleaning apparatus for cleaning the reactor member, the cleaning chamber being disposed adjacent to the first transfer chamber and capable of communicating with the first transfer chamber.

2. The vapor phase growth apparatus according to Claim 1, further comprising:
a reaction atmosphere unit which fills the reaction chamber with an inert gas;
a first transfer atmosphere unit which fills the first transfer chamber with the inert gas; and
a control unit which controls the reaction atmosphere unit and the first transfer atmosphere unit,
wherein the control unit makes the pressure of the inert gas in the first transfer chamber by the first transfer atmosphere unit higher than the pressure of the inert gas in the reaction chamber by the reaction atmosphere unit.

3. The vapor phase growth apparatus according to Claim 2, further comprising a cleaning atmosphere unit which fills the cleaning chamber with an inert gas.

4. The vapor phase growth apparatus according to Claim 2, further comprising:
a second transfer chamber storing a second transfer unit which is configured to transfer the wafer between the first transfer chamber, the second transfer chamber being arranged adjacent to the first transfer chamber and being capable of communicating with the first transfer chamber; and
a second transfer atmosphere unit which fills the second transfer chamber with the inert gas,
wherein the control unit makes the pressure of the inert gas in the second transfer chamber by the second transfer atmosphere unit higher than the pressure of the inert gas in the first transfer chamber by the first transfer atmosphere unit.

5. The vapor phase growth apparatus according to Claim 2, wherein a dew point of the inert gas is -40°C or lower and the inert gas does not contain oxygen gas.

6. The vapor phase growth apparatus according to Claim 1 or 2,
wherein the first transfer unit is capable of changing its orientation so as to face either the reaction chamber or the cleaning chamber with a support surface which supports the reactor member facing upward.
